# EUROPEAN PATENT APPLICATION

(11) **EP 4 524 217 A1**
(43) Date of publication of application: **19.03.2025**
(21) Application number: 23802495.4
(22) Date of filing: 20.03.2023
(51) Int. Cl.: C09K 21/12

(54) **ALKYL PHOSPHINATE COMPOSITION, AND PREPARATION METHOD THEREFOR AND USE THEREOF**

(30) Priority: 10.05.2022 CN 202210503927
(71) Applicant: Jiangsu Liside New Material Co., Ltd., Taizhou, Jiangsu 225500 (CN)
(72) Inventor: LI, Jinzhong, Taizhou, Jiangsu 225500 (CN); YANG, Jianwei, Taizhou, Jiangsu 225500 (CN)
(74) Representative: Eisenführ Speiser
(86) International application number: PCT/CN2023/082396
(87) International publication number: WO 2023/216719

(57) **Abstract**

Provided is an alkyl phosphinate composition, comprising: 99.5-99.9999 wt% of an alkyl phosphinate; and 0.0001-0.5 wt% of a long-chain phosphate. The particle size D95 of the alkyl phosphinate composition is less than 20 microns; the number of carbon atoms in the long-chain phosphate is 16-24. The composition of alkyl phosphinate powder can avoid agglomeration of ultra-fine powder flame retardant during use and improve the dispersion effect of ultra-fine alkyl phosphinate powder in epoxy resins and polyurethane, thereby avoiding granular white spots when used in materials such as printed circuit boards and films; moreover, the composition can meet processing and use requirements for alkyl phosphinate flame retardants, and does not reduce the flame retardant efficiency of alkyl phosphinate flame retardants. Also provided are a preparation method for and a use of the alkyl phosphinate composition.

## Description

This application claims the priority of Chinese Patent Application No. 202210503927.1, filed with the China National Intellectual Property Administration on May 10, 2022, and titled with "ALKYL PHOSPHINATE COMPOSITION, AND PREPARATION METHOD THEREFOR AND USE THEREOF", which is hereby incorporated by reference in its entirety.

### FIELD

The present disclosure belongs to the technical field of flame retardants, and specifically relates to an alkyl phosphinate composition and a preparation method therefor and use thereof, in particular, a highly dispersible ultra-fine alkyl phosphinate composition and a preparation method therefor and use thereof.

### BACKGROUND

Flame retardants are commonly used additives in industries such as electronic potting compounds and printed circuit boards. They play an important role in ensuring the fire safety of electronic and electrical components. In recent years, electronic products are evolving towards smaller sizes, lighter weights, and more intensive functions. Ultra-fine particles and high heat-resistance requirements have been proposed for the fillers and flame retardants used in potting compounds and printed circuit boards.

Alkyl phosphinate is a recently emerged, halogen-free, environmentally friendly flame retardant with high phosphorus content and efficient flame retardation, and yields good flame retardant results in small amounts. It also exhibits excellent thermal stability and has a thermal decomposition temperature exceeding 400°C, which can meet the processing needs of materials like nylon, high-temperature nylon, and polyesters. In addition, alkyl phosphinate contains alkyl in its molecular structure and displays good compatibility with organic resins. The addition of alkyl phosphinate exerts negligible influence on the mechanical and electrical performances of the resin. As a result, its applications in engineering plastics with high processing temperatures, high shear strength, and high CTI values are becoming increasingly widespread.

In recent years, with the development of the electronic and electrical industry, alkyl phosphinate has been used in electronic materials including printed circuit boards, electronic potting compounds and polyester films to prepare corresponding flame retardant products, which exhibit a good flame retardant effect. Alkyl phosphinate used in the above fields usually requires a fine particle size (D95 <20 microns) and an appropriate particle size distribution range, and the flame retardant (D95 <200 microns) employed in engineering plastics necessitates additional crushing and processing for finer particle size prior to application. The specific process typically involves mixing alkyl phosphinate with epoxy resin, polyurethane resin, acrylic resin, etc., and then coating the mixture on the surface of a film such as polyimide and polyester before baking, hot pressing or laminating to obtain the corresponding product. However, in actual use, it has been observed that as the particle size of alkyl phosphinate reduces, the crushed alkyl phosphinate is prone to agglomeration. When it is mixed with epoxy resin, polyurethane resin, acrylic resin, etc. and then coated on the surface of a printed circuit board or a polyester film material, the result may be the appearance of granular white spots on the surfaces of the printed circuit board and polyester film material. During the subsequent hot pressing and laminating processes, the surfaces of the printed circuit boards and film materials may develop bumps, spots or other abnormalities, which have a detrimental impact on the normal usage of printed circuit boards and polyester film materials, impeding workshop production efficiency, and leading to an influx of substandard products.

Therefore, it is crucial to modify the ultrafine alkyl phosphinate powder to avoid secondary agglomeration of the alkyl phosphinate powder after crushing and improve its dispersion in epoxy resin, polyurethane resin, and acrylic resin. The modified ultra-fine alkyl phosphinate powder can not only improve its own quality, but also greatly expand its application in electronic products such as printed circuit boards and polyester films.

In recent years, researchers have begun to study the dispersion of ultrafine powders using surface modification methods. In general, during the production, processing or post-processing of ultrafine powders, silicone coupling agents or long-chain fatty acid metal salt dispersants are added to improve the dispersion of ultrafine powders. How to better disperse ultrafine alkyl phosphinate powder has become a hot topic in the art.

### SUMMARY

In view of this, an object of the present disclosure is to provide an alkyl phosphinate composition and a preparation method therefor and use thereof. The alkyl phosphinate composition provided by the present disclosure has good dispersion and flame retardant effects.

The present disclosure provides an alkyl phosphinate composition, comprising:
alkyl phosphinate: 99.5-99.9999 wt%, and
long-chain phosphate: 0.0001-0.5 wt%;
wherein the number of carbon atoms in the long-chain phosphate is 16 to 24, and
the alkyl phosphinate composition has a particle size D95 of <20 microns.

Preferably, the long-chain phosphate is selected from the group consisting of long-chain sodium phosphate, long-chain potassium phosphate and a combination thereof.

Preferably, the long-chain phosphate is selected from the group consisting of a compound represented by Formula I-Formula III and a combination thereof: 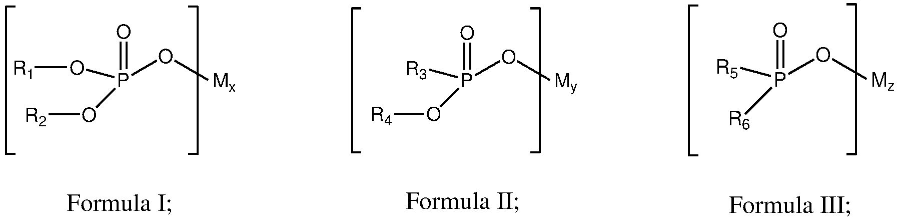
wherein, in Formula I, R₁ and R₂ are independently selected from the group consisting of H, C8-C16 alkyl, and aryl, M is sodium or potassium, and x is 1 or 2;
in Formula II, R₃ and R₄ are independently selected from the group consisting of H, C8-C16 alkyl, and aryl, M is sodium or potassium, and y is 1 or 2; and
in Formula III, R₅ and R₆ are independently selected from the group consisting of C7-C16 alkyl and aryl; M is sodium or potassium, and z is 1.

Preferably, the compound represented by Formula I is selected from the group consisting of disodium (potassium) monocetyloxy phosphate, disodium (potassium) monooctadecyloxy phosphate, sodium (potassium) ethoxy cetyloxy phosphate, sodium (potassium) propoxy cetyloxy phosphate, sodium (potassium) n-butoxy cetyloxy phosphate, sodium (potassium) isobutoxy cetyloxy phosphate, sodium (potassium) sec-butoxy cetyloxy phosphate, sodium (potassium) tert-butoxy cetyloxy phosphate, sodium (potassium) hexyloxy cetyloxy phosphate, sodium (potassium) octyloxy cetyloxy phosphate, sodium (potassium) n-butoxy dodecyloxy phosphate, sodium (potassium) isobutoxy dodecyloxy phosphate, sodium (potassium) sec-butoxy dodecyloxy phosphate, sodium (potassium) tert-butoxy dodecyloxy phosphate, sodium (potassium) hexyloxy dodecyloxy phosphate, sodium (potassium) n-octyloxy dodecyloxy phosphate, sodium (potassium) isooctyloxy dodecyloxy phosphate, sodium (potassium) diisooctoxy phosphate, sodium (potassium) di(dodecyloxy) phosphate, sodium (potassium) di-n-octyloxy phosphate, sodium (potassium) phenoxy dodecyloxy phosphate, sodium (potassium) phenoxy cetyloxy phosphate, sodium (potassium) o-dimethyl phenoxy dodecyloxy phosphate, sodium (potassium) o-dimethyl phenoxy cetyloxy phosphate, and a combination thereof.

Preferably, the compound represented by Formula II is selected from the group consisting of disodium (potassium) monocetyl phosphate, disodium (potassium) monooctadecyl phosphate, sodium (potassium) ethyl cetyloxy phosphate, sodium (potassium) propyl cetyloxy phosphate, sodium (potassium) n-butyl cetyloxy phosphate, sodium (potassium) isobutyl cetyloxy phosphate, sodium (potassium) sec-butyl cetyloxy phosphate, sodium (potassium) tert-butyl cetyloxy phosphate, sodium (potassium) hexyl cetyloxy phosphate, sodium (potassium) ethyl octadecyloxy phosphate, sodium (potassium) propyl octadecyloxy phosphate, sodium (potassium) n-butyl octadecyloxy phosphate, sodium (potassium) isobutyl octadecyloxy phosphate, sodium (potassium) sec-butyl octadecyloxy phosphate, sodium (potassium) tert-butyl cetyloxy phosphate, sodium (potassium) hexyl octadecyloxy phosphate, sodium (potassium) n-octyl n-octyloxy phosphate, sodium (potassium) isooctyl isooctyloxy phosphate, sodium (potassium) phenyl dodecyloxy phosphate, sodium (potassium) phenyl cetyloxy phosphate, sodium (potassium) phenyl octadecyloxy phosphate, sodium (potassium) o-dimethyl phenyl dodecyloxy phosphate, sodium (potassium) o-dimethyl phenyl cetyloxy phosphate, and a combination thereof.

Preferably, the compound represented by Formula III is selected from the group consisting of sodium (potassium) ethyl octadecyl phosphate, sodium (potassium) propyl octadecyl phosphate, sodium (potassium) n-butyl octadecyl phosphate, sodium (potassium) isobutyl octadecyl phosphate, sodium (potassium) sec-butyl octadecyl phosphate, sodium (potassium) tert-butyl octadecyl phosphate, sodium (potassium) hexyl octadecyl phosphate, sodium (potassium) ethyl cetyl phosphate, sodium (potassium) n-butyl cetyl phosphate, sodium (potassium) isobutyl cetyl phosphate, sodium (potassium) sec-butyl cetyl phosphate, sodium (potassium) tert-butyl cetyl phosphate, sodium (potassium) hexyl cetyl phosphate, sodium (potassium) octyl cetyl phosphate, sodium (potassium) n-butyl dodecyl phosphate, sodium (potassium) isobutyl dodecyl phosphate, sodium (potassium) sec-butyl dodecyl phosphate, sodium (potassium) tert-butyl dodecyl phosphate, sodium (potassium) hexyl dodecyl phosphate, sodium (potassium) n-octyl dodecyl phosphate, sodium (potassium) isooctyl dodecyl phosphate, sodium (potassium) didodecyl phosphate, sodium (potassium) diisooctyl phosphate, sodium (potassium) di-n-octyl phosphate, sodium (potassium) didecyl phosphate, sodium (potassium) phenyl dodecyl phosphate, sodium (potassium) phenyl cetyl phosphate, sodium (potassium) o-dimethyl phenyl dodecyl phosphate, sodium (potassium) o-dimethyl phenyl cetyl phosphate, and a combination thereof.

Preferably, the alkyl phosphinate has a content of 99.8-99.9999 wt%; and
the long-chain phosphate has a content of 0.0001-0.2 wt%.

Preferably, the alkyl phosphinate is a compound represented by Formula IV: 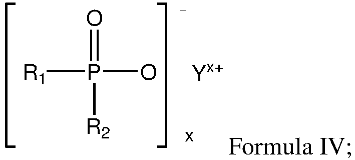
wherein, in Formula IV, R₁ and R₂ are independently alkyl;
Y is selected from the group consisting of aluminum, calcium, and magnesium; and
x is an integer of 2 or 3.

The present disclosure provides a method for preparing the alkyl phosphinate composition described in the above technical solution, comprising:
after performing filtration and washing during the preparation of alkyl phosphinate, mixing long-chain phosphate with the alkyl phosphinate; or
after completing metathesis during the preparation of alkyl phosphinate, mixing long-chain phosphate with the alkyl phosphinate.

The present disclosure provides a material, comprising: the alkyl phosphinate composition described in the above technical solution;
wherein, the material is selected from the group consisting of a printed circuit board, an electronic potting compound, a polyester film, and a combination thereof.

In the present disclosure, unlike the surface modification of conventional flame retardants and inorganic fillers, the modification of ultra-fine alkyl phosphinate powder needs to take into account the characteristics of the alkyl phosphinate itself and the impact of the working conditions during processing and use. Alkyl phosphinate has a high thermal decomposition temperature of over 400°C. When alkyl phosphinate is used in engineering plastics such as high-temperature nylon and nylon, the processing temperature is usually greater than 300°C. It is required that the addition of dispersants cannot lower the thermal decomposition temperature of alkyl phosphinate, and the dispersants cannot decompose, precipitate or deposit during the processing and use of alkyl phosphinate to cause changes in the appearance, mechanical and electrical properties of the flame retardant substrate. Moreover, the addition of dispersants cannot affect the normal use of alkyl phosphinate. For example, the addition of dispersants to epoxy resins cannot affect the curing time, glass transition temperature, etc. of the epoxy resin. Besides, the addition of dispersants cannot reduce the flame retardant efficiency of alkyl phosphinate.

The present disclosure conducts a comprehensive and systematic study on the dispersion of ultra-fine alkyl phosphinate, comprehensively considering the type of dispersant, the amount of dispersant added, as well as the addition and mixing methods used for surface modification of alkyl phosphinate powder, and also considering the impact of dispersants on the use and processing of alkyl phosphinate and on the performance of downstream products.

In view of the deficiencies in the use of existing ultra-fine alkyl phosphinate powders, the present disclosure provides an ultra-fine alkyl phosphinate powder composition and a method for preparing the composition. The alkyl phosphinate composition provided by the present disclosure can avoid the secondary agglomeration of ultra-fine powder flame retardant, significantly improve the dispersion effect of ultra-fine alkyl phosphinate powder in epoxy resin and polyurethane, avoid the generation of granular white spots when used in printed circuit boards and film materials, and meet the requirements for the processing and use of alkyl phosphinate flame retardants without reducing the flame retardant efficiency of alkyl phosphinate flame retardants.

### DETAILED DESCRIPTION

The technical solutions in the embodiments of the present disclosure will be described clearly and completely below. Apparently, the described examples are only some of the embodiments of the present disclosure, rather than all the embodiments. Based on the embodiments of the present disclosure, all other embodiments obtained by those of ordinary skill in the art without making inventive efforts fall within the protection scope of the present disclosure.

The present disclosure provides a highly dispersible alkyl phosphinate composition, comprising:
alkyl phosphinate, and
long-chain phosphates.

In order to solve the defects of the dispersion of ultra-fine alkyl phosphinate during use in the prior art, and of white spots and bumps in products due to the agglomeration to which ultra-fine alkyl phosphinate powder is prone in epoxy resin, polyurethane resin, and acrylic resin, the present disclosure has conducted extensive and in-depth research to examine methods for improving the dispersion of ultra-fine alkyl phosphinate, including the type, added amount and addition method of dispersion modifiers, and their effects of ultra-fine alkyl phosphinate in printed circuit boards and film materials. The present disclosure creatively discovered that adding trace amounts of C 16-C24 long-chain phosphate to alkyl phosphinate, combined with appropriate addition methods, can solve the problem of dispersion of alkyl phosphinate fairly well.

In the present disclosure, the alkyl phosphinate preferably has the structure represented by Formula IV: 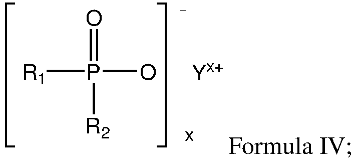
in Formula IV, R₁ and R₂ are independently alkyl;
Y is selected from the group consisting of aluminum, calcium, and magnesium; and
x is an integer of 2 or 3.

In the present disclosure, R₁ and R₂ are preferably independently selected from the group consisting of ethyl, propyl, and butyl, and more preferably independently selected from the group consisting of ethyl, n-propyl, isopropyl, n-butyl, isobutyl, and tert-butyl; and R₁ and R₂ may be the same or different.

In the present disclosure, the alkyl phosphinate is preferably aluminum diethyl phosphinate, which is a halogen-free flame retardant. It is mostly used in engineering plastics such as glass fiber reinforced nylon, high temperature nylon, and polyesters, and can also be used in electronic materials such as flexible printed circuit boards, electronic potting compounds, and polyester films, exerting a good flame retardant effect. However, the alkyl phosphine flame retardants used in these fields requires a fine particle size (D95 <20 microns) and an appropriate particle size distribution range, and the alkyl phosphine flame retardant necessitates additional grinding and crushing. In actual use, it has been observed that the crushed alkyl phosphinate is prone to second agglomeration. When epoxy resin and polyurethane resin glue mixed with alkyl phosphinate are coated on the surface of a printed circuit board or a polyester film material, the result may be the appearance of white spots on the surfaces of the printed circuit board and polyester film material, leading to quality problems such as bumps and white spots on the surface of the flexible circuit board and film material.

The present disclosure found through research that adding a small amount of C16-C24 long-chain phosphate modifier to ultra-fine alkyl phosphinate powder can reduce the secondary agglomeration of ultra-fine alkyl phosphinate powder and improve the dispersion effect of alkyl phosphinate powder in epoxy resin, polyurethane resin, and acrylic resin. The reason may be that alkyl phosphinate is weakly acidic (at room temperature, the pH of its saturated aqueous solution is about 4), while the long-chain phosphate is weakly alkaline and can adsorb modifiers to the surface of the modified solid particles with a good adsorption performance. Moreover, the long-chain phosphate has an amphiphilic structure and can be adsorbed on the surface of flame retardant powders, which reduces the surface energy of the flame retardant powder, thereby reducing the secondary agglomeration of ultra-fine alkyl phosphinate powder.

In the present disclosure, the particle size of the alkyl phosphinate is preferably D95: <20 microns; and the bulk density of the alkyl phosphinate is preferably 100-350 kg/m³, more preferably 150-300 kg/m³.

In the present disclosure, the alkyl phosphinate preferably further comprises water, and the water is generated during the production process of the alkyl phosphinate; and the mass content of the water in the alkyl phosphinate is preferably 0.01-1.0%, more preferably 0.01-0.5%, most preferably 0.05-0.4%. In the present disclosure, too low water content in the alkyl phosphinate will increase its production cost, and too high water content will affect the use effect of the alkyl phosphinate in thermosetting resins.

The present disclosure has no special restrictions on the source of the alkyl phosphinate, which can be purchased from the market or prepared according to methods well known to those skilled in the art. For example, aluminum diethyl phosphinate can be prepared according to the method disclosed in the patent CN103951699B, which comprises:
performing an addition reaction in a solvent using ethylene and sodium phosphinate as raw materials to obtain sodium diethyl phosphinate; 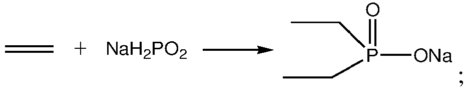
subjecting sodium diethyl phosphinate to a metathesis reaction with aluminum sulfate or aluminum chloride in water to obtain aluminum diethyl phosphinate: 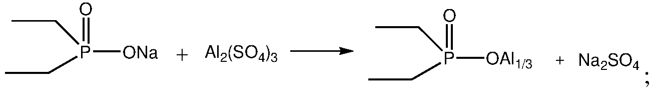 and
filtering and washing the obtained aluminum diethyl phosphinate to remove excess sodium sulfate by-products, and drying to obtain a finished product.

In the present disclosure, the long-chain phosphate contains phosphorus element and is non-flammable, and its appropriate molecular structure ensures its high thermal stability. Research has found that adding a trace amount of long-chain phosphate dispersant of the present disclosure will not affect the flame retardant efficiency of the alkyl phosphinate flame retardant. On the contrary, with the improvement of the dispersion of the alkyl phosphinate, the dispersion of the flame retardant powder becomes more uniform, which improves the flame retardant performance of the prepared circuit boards and film materials.

In the present disclosure, the number of carbon atoms in the long-chain phosphate is preferably 16 to 24. In the present disclosure, the long-chain phosphate is preferably selected from the group consisting of long-chain sodium phosphate, long-chain potassium phosphate and a combination thereof.

In the present disclosure, the long-chain phosphate modifier is C16-C24 long-chain phosphate. Research has found that shorter carbon chain results in greater polarity of the long-chain phosphate, and the affinity for the surface of the alkyl phosphinate is not sufficient, leading to not significant improvement in the dispersion effect. Moreover, phosphate with a short carbon chain has low solubility in organic solvents, such as ketones and esters, and poor compatibility with epoxy resin and polyurethane resin, and is prone to precipitation during the subsequent processing. Long-chain phosphate with a too long carbon chain has a too low thermal decomposition temperature and will decompose during the processing and use of printed circuit boards and polyester film materials, leading to problems such as yellowing and smoking during the hot pressing and laminating processes of printed circuit boards and polyester film materials, causing abnormal product quality. It is also found that the thermal stability of long-chain phosphate gradually decreases as the length of the carbon chain in the molecule increases, so it is necessary to choose an appropriate dispersant structure and appropriate carbon chain length.

In the present disclosure, the long-chain phosphate is selected from the group consisting of a compound represented by Formula I-Formula III and a combination thereof:

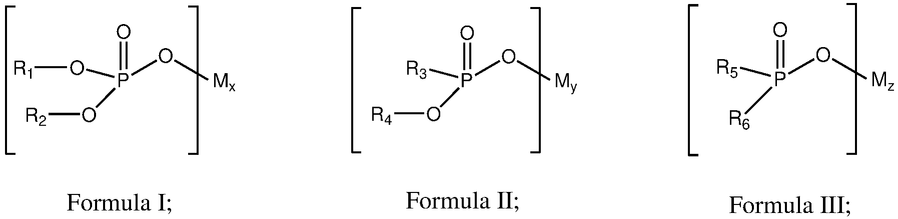

In the present disclosure, in Formula I, R₁ and R₂ are independently selected from the group consisting of H, C8-C16 alkyl and aryl, and are not both aryl; wherein the alkyl may be straight-chain alkyl or branched alkyl; the aryl is preferably selected from the group consisting of phenyl, o-methyl phenyl, m-methyl phenyl, p-methyl phenyl, and o-dimethyl phenyl; the sum of the number of carbon atoms in R₁ and R₂ is preferably 16 to 24; M is sodium or potassium; and x is 1 or 2.

In the present disclosure, the compound represented by Formula I is preferably selected from the group consisting of disodium (potassium) monocetyloxy phosphate, disodium (potassium) monooctadecyloxy phosphate, sodium (potassium) ethoxy cetyloxy phosphate, sodium (potassium) propoxy cetyloxy phosphate, sodium (potassium) n-butoxy cetyloxy phosphate, sodium (potassium) isobutoxy cetyloxy phosphate, sodium (potassium) sec-butoxy cetyloxy phosphate, sodium (potassium) tert-butoxy cetyloxy phosphate, sodium (potassium) hexyloxy cetyloxy phosphate, sodium (potassium) octyloxy cetyloxy phosphate, sodium (potassium) n-butoxy dodecyloxy phosphate, sodium (potassium) isobutoxy dodecyloxy phosphate, sodium (potassium) sec-butoxy dodecyloxy phosphate, sodium (potassium) tert-butoxy dodecyloxy phosphate, sodium (potassium) hexyloxy dodecyloxy phosphate, sodium (potassium) n-octyloxy dodecyloxy phosphate, sodium (potassium) isooctyloxy dodecyloxy phosphate, sodium (potassium) diisooctoxy phosphate, sodium (potassium) di(dodecyloxy) phosphate, sodium (potassium) di-n-octyloxy phosphate, sodium (potassium) phenoxy dodecyloxy phosphate, sodium (potassium) phenoxy cetyloxy phosphate, sodium (potassium) o-dimethyl phenoxy dodecyloxy phosphate, sodium (potassium) o-dimethyl phenoxy cetyloxy phosphate, and a combination thereof.

In the present disclosure, in Formula II, R₃ and R₄ are independently selected from the group consisting of H, C8-C16 alkyl and aryl, and are not both aryl; wherein the alkyl may be straight-chain alkyl or branched alkyl; the aryl is preferably selected from the group consisting of phenyl, o-methyl phenyl, m-methyl phenyl, p-methyl phenyl, and o-dimethyl phenyl; the sum of the number of carbon atoms in R₃ and R₄ is preferably 16 to 24; M is sodium ion or potassium ion; and y is 1 or 2.

**In** the present disclosure, the compound represented by Formula II is selected from the group consisting of disodium (potassium) monocetyl phosphate, disodium (potassium) monooctadecyl phosphate, sodium (potassium) ethyl cetyloxy phosphate, sodium (potassium) propyl cetyloxy phosphate, sodium (potassium) n-butyl cetyloxy phosphate, sodium (potassium) isobutyl cetyloxy phosphate, sodium (potassium) sec-butyl cetyloxy phosphate, sodium (potassium) tert-butyl cetyloxy phosphate, sodium (potassium) hexyl cetyloxy phosphate, sodium (potassium) ethyl octadecyloxy phosphate, sodium (potassium) propyl octadecyloxy phosphate, sodium (potassium) n-butyl octadecyloxy phosphate, sodium (potassium) isobutyl octadecyloxy phosphate, sodium (potassium) sec-butyl octadecyloxy phosphate, sodium (potassium) tert-butyl cetyloxy phosphate, sodium (potassium) hexyl octadecyloxy phosphate, sodium (potassium) n-octyl n-octyloxy phosphate, sodium (potassium) isooctyl isooctyloxy phosphate, sodium (potassium) phenyl dodecyloxy phosphate, sodium (potassium) phenyl cetyloxy phosphate, sodium (potassium) phenyl octadecyloxy phosphate, sodium (potassium) o-dimethyl phenyl dodecyloxy phosphate, sodium (potassium) o-dimethyl phenyl cetyloxy phosphate, and a combination thereof.

**In** the present disclosure, in Formula III, R₅ and R₆ are independently selected from the group consisting of C7-C16 alkyl and aryl, and are not both aryl; wherein the alkyl may be straight-chain alkyl or branched alkyl; the aryl is preferably selected from the group consisting of phenyl, o-methyl phenyl, m-methyl phenyl, p-methyl phenyl, and o-dimethyl phenyl; the sum of the number of carbon atoms in R₅ and R₆ is preferably 16 to 24; M is sodium ion or potassium ion; and z is an integer 1.

**In** the present disclosure, the compound represented by Formula III is preferably selected from the group consisting of sodium (potassium) ethyl octadecyl phosphate, sodium (potassium) propyl octadecyl phosphate, sodium (potassium) n-butyl octadecyl phosphate, sodium (potassium) isobutyl octadecyl phosphate, sodium (potassium) sec-butyl octadecyl phosphate, sodium (potassium) tert-butyl octadecyl phosphate, sodium (potassium) hexyl octadecyl phosphate, sodium (potassium) ethyl cetyl phosphate, sodium (potassium) n-butyl cetyl phosphate, sodium (potassium) isobutyl cetyl phosphate, sodium (potassium) sec-butyl cetyl phosphate, sodium (potassium) tert-butyl cetyl phosphate, sodium (potassium) hexyl cetyl phosphate, sodium (potassium) octyl cetyl phosphate, sodium (potassium) n-butyl dodecyl phosphate, sodium (potassium) isobutyl dodecyl phosphate, sodium (potassium) sec-butyl dodecyl phosphate, sodium (potassium) tert-butyl dodecyl phosphate, sodium (potassium) hexyl dodecyl phosphate, sodium (potassium) n-octyl dodecyl phosphate, sodium (potassium) isooctyl dodecyl phosphate, sodium (potassium) didodecyl phosphate, sodium (potassium) diisooctyl phosphate, sodium (potassium) di-n-octyl phosphate, sodium (potassium) didecyl phosphate, sodium (potassium) phenyl dodecyl phosphate, sodium (potassium) phenyl cetyl phosphate, sodium (potassium) o-dimethyl phenyl dodecyl phosphate, sodium (potassium) o-dimethyl phenyl cetyl phosphate, and a combination thereof.

The present disclosure has no special restrictions on the source of the long-chain alkyl salt, which can be purchased from the market, or can be prepared by using raw materials with corresponding structures according to chemical synthesis methods well known to those skilled in the art.

In the present disclosure, the mass content of the long-chain phosphate in the alkyl phosphinate composition is preferably 0.0001-0.5%, more preferably 0.0001-0.4%, further more preferably 0.0001-0.3%, and most preferably 0.0001-0.2%. In the present disclosure, as the particle size of the powder reduces, the amount of the long-chain phosphate needs to be appropriately increased, but the total amount is still within the range of 0.0001-0.5 wt%, preferably within the range of 0.0001-0.2 wt%. In the present disclosure, the amount of C16-C24 long-chain phosphate modifier added is 0.0001-0.5 wt%. Low amount does not have a significant effect on improving the dispersion of alkyl phosphinate, while excessive amount will lead to the precipitation of the long-chain phosphate dispersant, causing the flame-retardant substrate to absorb moisture, reduced mechanical properties and other changes. For example, in a case that the amount of sodium di-n-octoxy phosphate added to alkyl phosphinate is 0.7%, the duration of curing reaction of epoxy resin will be prolonged, the glass transition temperature of the cured epoxy resin will be reduced, and the peel strength of the epoxy resin copper-clad laminate will be reduced.

In the present disclosure, the alkyl phosphinate composition has a particle size distribution of D95: <20 µm and a bulk density of preferably 100 to 350 kg/m³.

The present disclosure provides a method for preparing the alkyl phosphinate composition described in the above technical solution, comprising:
after performing filtration and washing during the preparation of alkyl phosphinate, mixing long-chain phosphate with the alkyl phosphinate; or
after completing metathesis during the preparation of alkyl phosphinate, mixing long-chain phosphate with the alkyl phosphinate.

In the present disclosure, the method for preparing the alkyl phosphinate composition preferably comprises:
after performing filtration and washing during the preparation of alkyl phosphinate, mixing long-chain phosphate with the alkyl phosphinate.

In the present disclosure, the C16-C24 long-chain phosphate modifier can be added during the filtration and washing processes of alkyl phosphinate (aluminum diethyl phosphinate), or can be directly added to the metathesis kettle after the metathesis of alkyl phosphinate (aluminum diethyl phosphinate) is completed; preferably, it is added during the filtration and washing processes of alkyl phosphinate (aluminum diethyl phosphinate). In the present disclosure, the C16-C24 long-chain phosphate modifier is preferably added during the filtration and washing processes of alkyl phosphinate. In particular, after the filtration and washing operations of alkyl phosphinate are completed, a certain amount of an aqueous solution of long-chain phosphate is added to the wet material of alkyl phosphinate, and the mixture is left to stand, soaked, and then dried, so that the long-chain phosphate modifying dispersant remains in the alkyl phosphinate. In the alkyl phosphinate composition obtained by the above addition method, the content distribution of the long-chain phosphate is relatively uniform, which can ensure the best use effect during subsequent pulverizing, processing and use.

In the present disclosure, more preferably, the method for preparing the alkyl phosphinate composition comprises:
filtering and washing the obtained alkyl phosphinate slurry to obtain a wet material; and
mixing a solution of the long-chain phosphate with the wet material, keeping the temperature, leaving the mixture to stand, and drying to obtain the alkyl phosphinate composition.

In the present disclosure, the filtration (pressure filtration) and washing processes of the alkyl phosphinate are mainly the separation process of the alkyl phosphinate from by-products such as water and sodium sulfate, and common solid-liquid separation equipment can be used.

In the present disclosure, the filtration is preferably performed in a filter, and the filter is preferably selected from the group consisting of a belt filter, a scraper filter, a flat plate filtering and washing two-in-one machine, a flat plate filtering, washing and drying three-in-one machine, a butterfly filter, a disc filter, and a plate and frame filter press; and the washing is preferably performed by adding water to wash. By-products such as sodium sulfate in the alkyl phosphinate slurry are removed through filtration and washing.

In the present disclosure, the long-chain phosphate is preferably added in the form of a long-chain phosphate solution obtained from dilution with water. In the present disclosure, the long-chain phosphate solution is preferably an aqueous solution of long-chain phosphate; and the mass concentration of the long-chain phosphate solution is preferably 0.01-5.0%, more preferably 0.02-2.0%. In the present disclosure, a low concentration of the long-chain phosphate solution can improve its dispersion effect, but it also increases the duration of the drying process, which reduces production efficiency and increases energy consumption. A high concentration of the long-chain phosphate will cause the long-chain phosphate to precipitate during storage and addition, which cannot guarantee the usage effect of the long-chain phosphate.

In the present disclosure, keeping the temperature is performed at a temperature of preferably 70-100°C, more preferably 80-90°C, and most preferably 95°C, for preferably 2-4 hours, more preferably 3 hours; and the drying is preferably vacuum drying, and is performed at a temperature of preferably 130-170°C, more preferably 140-160°C, and most preferably 150°C.

In the present disclosure, the alkyl phosphinate composition after washing and drying has a particle size distribution of preferably D50: 10-150 µm and a bulk density of preferably 300-1500 kg/m³, more preferably 500-1200 kg/m³, and most preferably 700-1000 kg/m³.

In the present disclosure, after the drying, the method preferably further comprises:
pulverizing and/or grinding the obtained dried product to obtain an alkyl phosphinate composition with a desired particle size distribution.

In the present disclosure, the pulverizing is preferably carried out using a jet mill, and the gas pressure during the pulverizing process is preferably 0.4-0.8 MPa.

In the present disclosure, the alkyl phosphinate composition has a particle size distribution of D95: <20 µm and a bulk density of preferably 100 to 350 kg/m³.

The present disclosure provides a material comprising: the alkyl phosphinate composition described in the above technical solution.

In the present disclosure, the alkyl phosphinate composition has a particle size distribution of D95: <20 µm and a bulk density of preferably 100 to 350 kg/m³.

In the present disclosure, the material is selected from the group consisting of a printed circuit board, an electronic potting compound, a polyester film and a combination thereof.

In the present disclosure, the alkyl phosphinate composition can be used in a printed circuit board, an electronic potting compound and a polyester film. The alkyl phosphinate composition can be pulverized and added to an organic resin (such as epoxy resin, polyurethane resin or acrylic resin) to prepare slurry, which is then applied on the surface of the product required for flame retardant.

The present disclosure provides an alkyl phosphinate composition, in which adding a small amount of C16-C24 long-chain phosphate dispersant to the alkyl phosphinate can modify the dispersibility of ultra-fine alkyl phosphinate, which solves the problem that ultra-fine alkyl phosphinate powder is prone to agglomeration in epoxy resin, polyurethane resin, and acrylic resin, and white spot particles and bumps appear in products. The addition of the dispersant in the present disclosure does not affect the thermal stability of the alkyl phosphinate, and the dispersant does not decompose during the processing and use of the alkyl phosphinate. The addition of the dispersant will not reduce the flame retardant efficiency of the alkyl phosphinate, and has little impact on the use of the alkyl phosphinate in epoxy resin, polyurethane resin, and acrylic resin.

In the following examples of the present disclosure, the epoxy resin is NPPN-438, provided by Nanya Electronic Materials (Kunshan) Co., Ltd.; the PET film is 0.8*400*400 mm³, provided by Hangzhou Dahua Plastics Co., Ltd.; the sodium (potassium) dialkoxy phosphate can be prepared by referring to the method disclosed in patent CN104109170; the sodium (potassium) alkyl alkoxy phosphate can be prepared by referring to the method disclosed in the literature (Synthesis of Monooctyl Octyl Phosphate and Study on the Structural Properties of Extraction of Lanthanide Elements, Journal of the Chinese Society of Rare Earths, 1985 (3), 13-19); and other raw materials are commercially available products purchased through commercial channels.

The gas pressure during pulverizing by the experimental jet pulverizer is 0.4-0.8 MPa.

### Example 1

274.1 g of sodium phosphinate was dissolved in 1600 g of water. Then the solution was transferred to a 3 L pressure kettle, added with 3 g of concentrated sulfuric acid and 36 g of n-butanol, heated to 95°C, and introduced with ethylene. The pressure in the reaction kettle was controlled to be constant at 0.3 MPa. Then a sodium percarbonate solution with a concentration of 2% was continuously pumped in using a peristaltic pump. The reaction was ended in about 2.5 hours. Then the pressure and temperature of the reactor was reduced, wherein the temperature was reduced to about 90°C. 625.1 g of a hydrated aluminum sulfate solution with a concentration of 46 wt% was added to the reaction kettle within 60 minutes, and white precipitate gradually precipitated, which was then filtered, washed with hot water, and suction-filtered until there were no droplets in the funnel to obtain an aluminum diethyl phosphinate filter cake.

The aluminum diethyl phosphinate filter cake was added with 35.8 g of an aqueous solution of disodium monocetyl phosphate with a concentration of 1.0 wt%, soaked for 3 hours, kept at a temperature of 78°C, and then filtered. The obtained filter cake was dried directly under vacuum at 150°C.

The above-mentioned dried product was added into an airflow pulverizer, and the carrier gas pressure and classification wheel speed during pulverization were adjusted to obtain an ultra-fine aluminum diethyl phosphinate composition product with D95 of 14.6 µm and a bulk density of 260 kg/m³.

### Example 2

An aluminum diethyl phosphinate filter cake was prepared according to the method of Example 1.

The aluminum diethyl phosphinate filter cake was added with 139.0 g of an aqueous solution of sodium n-octyl n-octoxy phosphate with a concentration of 1.0 wt%, soaked for 2 hours, kept at a temperature of 70°C, and then filtered. The obtained filter cake was dried directly under vacuum at 150°C.

The above-mentioned dried product was added into an airflow pulverizer, and the carrier gas pressure and classification wheel speed during pulverization were adjusted to obtain an ultra-fine aluminum diethyl phosphinate composition product with D95 of 4.8 µm and a bulk density of 201 kg/m³.

### Example 3

An aluminum diethyl phosphinate filter cake was prepared according to the method of Example 1.

The aluminum diethyl phosphinate filter cake was added with 36.9 g of an aqueous solution of sodium diisooctyl phosphate with a concentration of 0.1 wt%, soaked for 2.5 hours, kept at a temperature of 90°C, and then filtered. The obtained filter cake was dried directly under vacuum at 150°C.

The above-mentioned dried product was added into an airflow pulverizer, and the carrier gas pressure and classification wheel speed during pulverization were adjusted to obtain an ultra-fine aluminum diethyl phosphinate composition product with D95 of 4.8 µm and a bulk density of 208 kg/m³.

### Example 4

An aluminum diethyl phosphinate filter cake was prepared according to the method of Example 1.

The aluminum diethyl phosphinate filter cake was added with 3.49 g of an aqueous solution of potassium di(dodecyloxy) phosphate with a concentration of 0.02 wt%, soaked for 4 hours, kept at a temperature of 80°C, and then filtered. The obtained filter cake was dried directly under vacuum at 150°C.

The above-mentioned dried product was added into an airflow pulverizer, and the carrier gas pressure and classification wheel speed during pulverization were adjusted to obtain an ultra-fine aluminum diethyl phosphinate composition product with D95 of 18.9 µm and a bulk density of 291 kg/m³.

### Example 5

An aluminum diethyl phosphinate filter cake was prepared according to the method of Example 1.

The aluminum diethyl phosphinate filter cake was added with a mixed solution of 7.0 g of sodium phenoxy dodecyloxy phosphate with a concentration of 0.5 wt% and 7.3 g of sodium di-n-octyloxy phosphate with a concentration of 0.5 wt%, soaked for 2.5 hours, kept at a temperature of 100°C, and then filtered. The obtained filter cake was dried directly under vacuum at 150°C.

The above-mentioned dried product was added into an airflow pulverizer, and the carrier gas pressure and classification wheel speed during pulverization were adjusted to obtain an ultra-fine aluminum diethyl phosphinate composition product with D95 of 8.9 µm and a bulk density of 215 kg/m³.

### Example 6

An aluminum diethyl phosphinate filter cake was prepared according to the method of Example 1.

The aluminum diethyl phosphinate filter cake was added with 36.6 g of an aqueous solution of sodium di(isooctyloxy) phosphate with a concentration of 0.01 wt%, soaked for 3 hours, kept at a temperature of 80°C, and then filtered. The obtained filter cake was dried directly under vacuum at 150°C.

The above-mentioned dried product was added into an airflow pulverizer, and the carrier gas pressure and classification wheel speed during pulverization were adjusted to obtain an ultra-fine aluminum diethyl phosphinate composition product with D95 of 13.4 µm and a bulk density of 244 kg/m³.

### Comparative Example 1

An ultra-fine aluminum diethyl phosphinate composition product with the same particle size distribution as Example 1 was prepared according to the method of Example 1, except that the filter cake was kept at a temperature of 50°C and then filtered.

### Comparative Example 2

An ultra-fine aluminum diethyl phosphinate composition product with the same particle size distribution as Example 2 was prepared according to the method of Example 2, except that the sodium n-octyl n-octoxy phosphate solution had a concentration of 1.5 wt%.

### Comparative Example 3

An ultra-fine aluminum diethyl phosphinate composition product with the same particle size distribution as Example 3 was prepared according to the method of Example 3, except that the sodium diisooctyl phosphate solution was replaced with an equal amount of sodium dihexyl phosphate solution with the same concentration.

### Comparative Example 4

An ultra-fine aluminum diethyl phosphinate composition product with the same particle size distribution as Example 4 was prepared according to the method of Example 4, except that the potassium di(dodecyloxy) phosphate solution had a concentration of 0.006 wt%.

### Comparative Example 5

An ultra-fine aluminum diethyl phosphinate composition product with the same particle size distribution as Example 5 was prepared according to the method of Example 5, except that the mixed solution of 7.0 g of sodium phenoxy dodecyloxy phosphate with a concentration of 0.5 wt% and 7.3 g of sodium di-n-octyloxy phosphate with a concentration of 0.5 wt% was replaced with 14.5 g of potassium di(cetyloxy) phosphate solution with a concentration of 0.5 wt%.

### Comparative Example 6

An ultra-fine aluminum diethyl phosphinate composition product with the same particle size distribution as Example 6 was prepared according to the method of Example 6, except that 36.6 g of an aqueous solution of sodium diisooctoxy phosphate with a concentration of 0.01 wt% was replaced with 36.7 g of sodium cetyloxy sulfonate solution with a concentration of 0.01 wt%.

### Comparative Example 7

An ultra-fine aluminum diethyl phosphinate composition product with the same particle size distribution as Example 6 was prepared according to the method of Example 6, except that no aqueous solution of long-chain phosphate was added.

### Performance measurement

Measurement of water content: The measurement was conducted using the Karl Fischer method.

Measurement of particle size distribution: The alkyl phosphinate flame retardant powders prepared in the Examples and Comparative Examples were dispersed in ethanol or acetone, and subjected to measurement using the laser scattering method.

Measurement of powder dispersibility: 80.0 g of epoxy resin and 4.0 g of dicyandiamide (curing agent) were added to 150 mL of butanone, stirred, dispersed, and then added with 9.0 g of the alkyl phosphinate flame retardant prepared in the Examples and Comparative Examples. The mixture was stirred at a high speed, dispersed, and then scraped on a PET film using a scraper disperser. The dispersion of alkyl phosphinate on the film was inspected visually, and the numbers of white spots with a diameter of 0.2-0.5 mm and above 0.5 mm were recorded.

Measurement of long-chain phosphate content: Anionic long-chain phosphate was measured using ion chromatography (IC) or ultra-performance liquid chromatography (UPLC). Measurement conditions: The sample was dispersed in water or methanol, adjusted to volume, and then ultrasonicated. The supernatant liquid was taken for measurement. Cationic sodium ions or potassium ions were measured using inductively coupled plasma spectroscopy (ICP).

Measurement of flame retardant performance: The epoxy resin glue after the measurement of powder dispersibility was poured into a tetrafluoroethylene mold for further curing to obtain a sample strip. The measurement was performed according to the UL94 V0 (1.6 mm) method, each group of 5 to 6 sample strips, referring to GB-T 2408-2008 standards.

The products prepared by the Examples and Comparative Examples of the present disclosure were subjected to the above-mentioned performance measurements. The measurement results are as follows:

| | | Exa mpl e 1 | Exa mpl e 2 | Exa mpl e 3 | Exa mpl e 4 | Exa mpl e 5 | Exa mpl e 6 | Com parati ve Exam ple 1 | Com parati ve Exam ple 2 | Com parati ve Exam ple 3 | Com parati ve Exam ple 4 | Com parati ve Exam ple 5 | Com parati ve Exam ple 6 | Com parati ve Exam ple 7 |
|---|---|---|---|---|---|---|---|---|---|---|---|---|---|---|
| Long chain phosphate Content/% | | 0.1 | 0.4 | 0.0 1 | 0.0 002 | 0.0 2 | 0.0 01 | 0.1 | 0.6 | 0.01 | 0.000 06 | 0.02 | 0.001 | Not detect ed |
| Water content, % | | 0.1 2 | 0.1 1 | 0.1 0 | 0.1 1 | 0.1 0 | 0.0 9 | 0.12 | 0.11 | 0.10 | 0.12 | 0.11 | 0.09 | 0.09 |
| Coating appearanc e | | Uni for m whi te | Uni for m whi te | Uni for m whi te | Uni for m whi te | Uni for m whi te | Uni for m whi te | With partic les on the surfa ce | Unifo rm white | With partic les on the surfa ce | With partic les on the surfa ce | With partic les on the surfa ce | With partic les on the surfa ce | With partic les on the surfa ce |
| Nu mb er of whi te spo ts | 0.2-0.5 mm | 0 | 0 | 0 | 0 | 0 | 0 | 3 | 0 | 2 | 3 | 2 | 3 | 5 |
| | Dia met er grea ter than 0.5 mm | 0 | 0 | 0 | 0 | 0 | 0 | 0 | 0 | 1 | 1 | 0 | 3 | 4 |
| Flame retardant performan ce | | V0 | V0 | V0 | V0 | V0 | V0 | V0 | V0 | V0 | V0 | V0 | V1 | V0 |
| Note | | | | | | | | | Mater ial surfa ce absor bed moist ure | | | Samp le turne d yello w | Samp le turne d gray | |

It can be seen from the above measurement results that after the C16-C24 long-chain phosphate was added to the alkyl phosphinate, the ultra-fine alkyl phosphinate powder showed a good dispersion modification effect, and the coating appearance of the obtained product had no abnormal agglomeration, white spots or granular substances. The long-chain phosphate dispersant with 12 carbon atoms of the long chain and the long-chain phosphate dispersant with 32 carbon atoms of the long chain had relatively poor effects. In particular, the long-chain phosphate dispersant with 32 carbon atoms of the longchain caused the flame retardant sample to turn yellow. Adding other dispersants, such as sulfonate, cannot improve the dispersibility and would cause abnormalities in the alkyl phosphinate.

The present disclosure provides an alkyl phosphinate composition, in which adding a small amount of C16-C24 long-chain phosphate dispersant to the alkyl phosphinate can modify the dispersibility of ultra-fine alkyl phosphinate, which solves the problem that ultra-fine alkyl phosphinate powder is prone to agglomeration in epoxy resin, polyurethane resin, and acrylic resin, and white spot particles and bumps appear in products. The addition of the dispersant in the present disclosure does not affect the thermal stability of the alkyl phosphinate, and the dispersant does not decompose during the processing and use of the alkyl phosphinate. The addition of the dispersant will not reduce the flame retardant efficiency of the alkyl phosphinate, and has little impact on the use of the alkyl phosphinate in epoxy resin, polyurethane resin, and acrylic resin.

The above are only preferred embodiments of the present disclosure. It should be noted that those of ordinary skill in the art can make several improvements and modifications without departing from the principles of the present disclosure. These improvements and modifications should also be considered as within the protection scope of the present disclosure.

## Claims

1. An alkyl phosphinate composition, comprising:
alkyl phosphinate: 99.5-99.9999 wt%, and
long-chain phosphate: 0.0001-0.5 wt%;
wherein the number of carbon atoms in the long-chain phosphate is 16 to 24, and
the alkyl phosphinate composition has a particle size D95 of <20 microns.

2. The alkyl phosphinate composition according to claim 1, wherein the long-chain phosphate is selected from the group consisting of long-chain sodium phosphate, long-chain potassium phosphate and a combination thereof.

3. The alkyl phosphinate composition according to claim 2, wherein the long-chain phosphate is selected from the group consisting of a compound represented by Formula I-Formula III and a combination thereof: 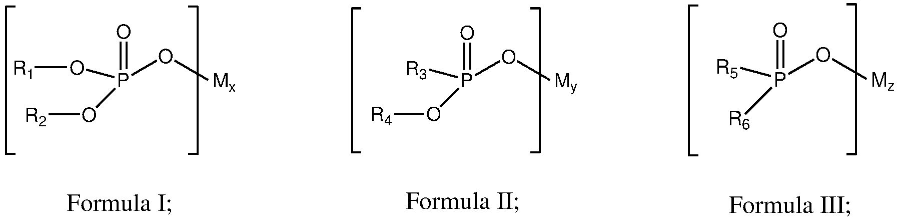
wherein, in Formula I, R₁ and R₂ are independently selected from the group consisting of H, C8-C16 alkyl, and aryl, M is sodium or potassium, and x is 1 or 2;
in Formula II, R₃ and R₄ are independently selected from the group consisting of H, C8-C16 alkyl, and aryl, M is sodium or potassium, and y is 1 or 2; and
in Formula III, R₅ and R₆ are independently selected from the group consisting of C7-C16 alkyl and aryl; M is sodium or potassium, and z is 1.

4. The alkyl phosphinate composition according to claim 3, wherein the compound represented by Formula I is selected from the group consisting of disodium (potassium) monocetyloxy phosphate, disodium (potassium) monooctadecyloxy phosphate, sodium (potassium) ethoxy cetyloxy phosphate, sodium (potassium) propoxy cetyloxy phosphate, sodium (potassium) n-butoxy cetyloxy phosphate, sodium (potassium) isobutoxy cetyloxy phosphate, sodium (potassium) sec-butoxy cetyloxy phosphate, sodium (potassium) tert-butoxy cetyloxy phosphate, sodium (potassium) hexyloxy cetyloxy phosphate, sodium (potassium) octyloxy cetyloxy phosphate, sodium (potassium) n-butoxy dodecyloxy phosphate, sodium (potassium) isobutoxy dodecyloxy phosphate, sodium (potassium) sec-butoxy dodecyloxy phosphate, sodium (potassium) tert-butoxy dodecyloxy phosphate, sodium (potassium) hexyloxy dodecyloxy phosphate, sodium (potassium) n-octyloxy dodecyloxy phosphate, sodium (potassium) isooctyloxy dodecyloxy phosphate, sodium (potassium) diisooctoxy phosphate, sodium (potassium) di(dodecyloxy) phosphate, sodium (potassium) di-n-octyloxy phosphate, sodium (potassium) phenoxy dodecyloxy phosphate, sodium (potassium) phenoxy cetyloxy phosphate, sodium (potassium) o-dimethyl phenoxy dodecyloxy phosphate, sodium (potassium) o-dimethyl phenoxy cetyloxy phosphate, and a combination thereof.

5. The alkyl phosphinate composition according to claim 3, wherein the compound represented by Formula II is selected from the group consisting of disodium (potassium) monocetyl phosphate, disodium (potassium) monooctadecyl phosphate, sodium (potassium) ethyl cetyloxy phosphate, sodium (potassium) propyl cetyloxy phosphate, sodium (potassium) n-butyl cetyloxy phosphate, sodium (potassium) isobutyl cetyloxy phosphate, sodium (potassium) sec-butyl cetyloxy phosphate, sodium (potassium) tert-butyl cetyloxy phosphate, sodium (potassium) hexyl cetyloxy phosphate, sodium (potassium) ethyl octadecyloxy phosphate, sodium (potassium) propyl octadecyloxy phosphate, sodium (potassium) n-butyl octadecyloxy phosphate, sodium (potassium) isobutyl octadecyloxy phosphate, sodium (potassium) sec-butyl octadecyloxy phosphate, sodium (potassium) tert-butyl cetyloxy phosphate, sodium (potassium) hexyl octadecyloxy phosphate, sodium (potassium) n-octyl n-octyloxy phosphate, sodium (potassium) isooctyl isooctyloxy phosphate, sodium (potassium) phenyl dodecyloxy phosphate, sodium (potassium) phenyl cetyloxy phosphate, sodium (potassium) phenyl octadecyloxy phosphate, sodium (potassium) o-dimethyl phenyl dodecyloxy phosphate, sodium (potassium) o-dimethyl phenyl cetyloxy phosphate, and a combination thereof.

6. The alkyl phosphinate composition according to claim 3, wherein the compound represented by formula III is selected from the group consisting of sodium (potassium) ethyl octadecyl phosphate, sodium (potassium) propyl octadecyl phosphate, sodium (potassium) n-butyl octadecyl phosphate, sodium (potassium) isobutyl octadecyl phosphate, sodium (potassium) sec-butyl octadecyl phosphate, sodium (potassium) tert-butyl octadecyl phosphate, sodium (potassium) hexyl octadecyl phosphate, sodium (potassium) ethyl cetyl phosphate, sodium (potassium) n-butyl cetyl phosphate, sodium (potassium) isobutyl cetyl phosphate, sodium (potassium) sec-butyl cetyl phosphate, sodium (potassium) tert-butyl cetyl phosphate, sodium (potassium) hexyl cetyl phosphate, sodium (potassium) octyl cetyl phosphate, sodium (potassium) n-butyl dodecyl phosphate, sodium (potassium) isobutyl dodecyl phosphate, sodium (potassium) sec-butyl dodecyl phosphate, sodium (potassium) tert-butyl dodecyl phosphate, sodium (potassium) hexyl dodecyl phosphate, sodium (potassium) n-octyl dodecyl phosphate, sodium (potassium) isooctyl dodecyl phosphate, sodium (potassium) didodecyl phosphate, sodium (potassium) diisooctyl phosphate, sodium (potassium) di-n-octyl phosphate, sodium (potassium) didecyl phosphate, sodium (potassium) phenyl dodecyl phosphate, sodium (potassium) phenyl cetyl phosphate, sodium (potassium) o-dimethyl phenyl dodecyl phosphate, sodium (potassium) o-dimethyl phenyl cetyl phosphate, and a combination thereof.

7. The alkyl phosphinate composition according to claim 1, wherein the alkyl phosphinate has a content of 99.8-99.9999 wt%; and
the long-chain phosphate has a content of 0.0001-0.2 wt%.

8. The alkyl phosphinate composition according to claim 1, wherein the alkyl phosphinate is a compound represented by Formula IV: 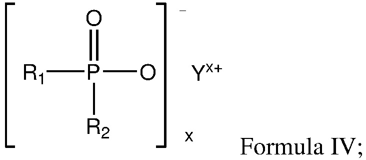
wherein, in Formula IV, R₁ and R₂ are independently alkyl;
Y is selected from the group consisting of aluminum, calcium, and magnesium; and
x is an integer of 2 or 3.

9. A method for preparing the alkyl phosphinate composition according to claim 1, comprising:
after performing filtration and washing during the preparation of alkyl phosphinate, mixing long-chain phosphate with the alkyl phosphinate; or
after completing metathesis during the preparation of alkyl phosphinate, mixing long-chain phosphate with the alkyl phosphinate.

10. A material, comprising the alkyl phosphinate composition according to claim 1;
wherein the material is selected from the group consisting of a printed circuit board, an electronic potting compound, a polyester film, and a combination thereof.
